# EUROPÄISCHE PATENTSCHRIFT

(11) **EP 3 535 637 B1**
(45) Veröffentlichungstag und Bekanntmachung des Hinweises auf die Patenterteilung: **11.08.2021**
(21) Anmeldenummer: 17797892.1
(22) Anmeldetag: 27.10.2017
(51) Int. Cl.: G05G 1/00, G06F 3/01, G06F 3/03, G06F 3/039, G06F 3/041, H03K 17/00, G06F 3/0362, B60K 35/00, B60K 37/06, H01F 38/18, B60R 16/027, G08C 17/00, B60R 16/02, G06F 3/0488, G06F 3/046, B60Q 3/64, B60Q 3/14

(54) **BEDIENVORRICHTUNG FÜR EINE FAHRZEUGKOMPONENTE**
OPERATING DEVICE FOR A VEHICLE COMPONENT
DISPOSITIF DE COMMANDE POUR UN COMPOSANT DE VÉHICULE

(30) Priorität: 04.11.2016 DE 102016121076
(43) Veröffentlichungstag der Anmeldung: 11.09.2019
(73) Patentinhaber: Behr-Hella Thermocontrol GmbH, 70469 Stuttgart (DE)
(72) Erfinder: MASTHOFF, Klaus-Martin, 59557 Lippstadt (DE); SCHWAB, Tobias, 59557 Lippstadt (DE); STALLEIN, Matthias, 59557 Lippstadt (DE)
(74) Vertreter: dompatent von Kreisler Selting Werner - Partnerschaft von Patent- und Rechtsanwälten mbB
(86) Internationale Anmeldenummer: PCT/EP2017/077653
(87) Internationale Veröffentlichungsnummer: WO 2018/083039

(56) Entgegenhaltungen:
- EP-A2- 2 251 762
- DE-A1-102006 026 187
- DE-A1-102010 010 574
- DE-U1-202015 101 334

## Beschreibung

Die Erfindung betrifft eine Bedienvorrichtung für eine Fahrzeugkomponente und insbesondere ein Mensch-Maschine-Interface, auch MMI oder HMI (Human-Machine-Interface) genannt, für Fahrzeuge.

Bedienvorrichtungen für Fahrzeugkomponenten sollten zur Steigerung ihrer Akzeptanz beim Benutzer über einen hohen Grad an Bedienkomfort verfügen. Bekannt sind Bedienelementeinheiten mit Tasten und/oder Drehstellern, wobei in zunehmendem Maße dazu übergegangen wird, derartige Bedienelemente mit "eigenen" Anzeigeelementen bzw. Anzeigevorrichtungen, also Displays, auszustatten. Diese Komponenten benötigen für ihren Betrieb elektrische Energie, die wegen der Aufrechterhaltung der Betriebssicherheit dauerhaft zur Verfügung stehen und daher typischerweise per Kabel zugeführt wird.

Eine batterielose Tastatur und ein batterieloses Zeigegerät (Maus) ist aus DE-A-198 54 367 bekannt, wobei anzumerken ist, dass eine derartige Dateneingabevorrichtung bei dem Design einer Bedieneinheit für ein Fahrzeug nicht in Betracht bezogen wird.

Weitere Dateneingabe- und -übertragungsvorrichtungen sind in DE-A-196 52 491 und DE-U-20 2015 101 334 beschrieben.

DE-A-10-2010 010 574 zeigt eine Bedienvorrichtung für ein Fahrzeug, welche eine berührungssensitive Oberfläche und ein Einstellelement umfasst.

Sowohl konstruktiv als auch hinsichtlich einer Reduzierung des Montageaufwands von Vorteil ist es, wenn die Energiezufuhr zu elektrischen bzw. elektronischen Komponenten von Bedienelementeinheiten in Fahrzeugen vereinfacht werden könnte, wobei eine Schwierigkeit unter anderem darin besteht, den EMV-Anforderungen bei Kraftfahrzeugen genügen zu müssen.

Aufgabe der Erfindung ist es daher, eine Bedienvorrichtung für eine Fahrzeugkomponente zu schaffen, deren Gehäuse mit einer insbesondere "aufgesetzten" bzw. "aufsetzbaren" Bedienelementeinheit versehen ist, deren Energiezufuhr konstruktiv vereinfacht ist.

Zur Lösung dieser Aufgabe wird mit der Erfindung eine Bedienvorrichtung für eine Fahrzeugkomponente, insbesondere Mensch-Maschine-Interface (MMI - oder Human-Machine-Interface HMI) für Fahrzeuge, vorgeschlagen, wobei die Bedienvorrichtung versehen ist mit den Merkmalen des Anspruchs 1.

Einzelne Ausgestaltungen der Erfindung sind Gegenstand der Unteransprüche.

Im Folgenden wird die Erfindung anhand der Beispiele einer Anzeigevorrichtung bzw. eines Anzeigeelements und/oder einer Funktionssensorik (Drück-, Dreh-, Force-Sense-, Force-Feedback-Funktion) als elektrischer Verbraucher beschrieben. Das allerdings soll den Umfang der Erfindung nicht einschränken.

Nach der Erfindung ist also vorgesehen, die für den Betrieb der Bedieneinheit erforderliche elektrische Energie induktiv in eine Energieversorgungseinheit der Bedienelementeinheit einzuspeisen. Damit erfolgt die Energiezufuhr drahtlos, was den Konstruktions- und Montageaufwand der Bedienvorrichtung reduziert. Insbesondere ist es nun möglich, eine mit elektrischer Energie zu versorgende Bedienelementeinheit an der Vorderseite des Gehäuses auch abnehmbar positionieren zu können. Dies kann unter Umständen auch aus sicherheitstechnischen Aspekten geschehen, um nämlich einen unautorisierten Zugang zum Fahrzeug wenig attraktiv erscheinen zu lassen, da trotz unautorisiertem Zugang zum Fahrzeug dessen Betrieb entweder gar nicht oder nur eingeschränkt möglich ist.

Die Energieversorgung der Bedienelementeinheit könnte sicherlich auch dadurch erfolgen, dass die Bedienelementeinheit über eine auswechselbare Batterie oder einen an ein Ladegerät anschließbaren wiederaufladbaren Akku verfügt. Durch die erfindungsgemäße induktive Energieeinspeisung jedoch wird stets garantiert, dass die Bedienelementeinheit über ausreichend elektrische Energie verfügt, ohne dass der Fahrer für das Auswechseln der Batterie oder das Laden des Akkus Sorge tragen muss.

Erfindungsgemäß befindet sich eine erste (Energieübertragungs-)Spule im Gehäuse, und zwar der Rückseite der Vorderwand des Gehäuses zugewandt, während eine zweite (Energieübertragungs-)Spule in der Bedienelementeinheit angeordnet ist. Es ist auch denkbar, dass das Gehäuse mit mehreren ersten Spulen versehen ist, die nebeneinander angeordnet sind, so dass je nach Positionierung der in diesem Falle abnehmbar ausgeführten Bedienelementeinheit auf der Vorderwand des Gehäuses die zweite Spule von einer der ersten Spulen mit Energie versorgt wird, um elektrische Energie in die zweite Spule induktiv einzuspeisen. Die ersten Spulen können kodiert sein, so dass die Bedienvorrichtung Informationen darüber erlangt, welche der ersten Spulen aktuell die Bedienelementeinheit mit elektrischer Energie versorgt bzw. mit ihr kommuniziert. Dadurch lässt sich z.B. auf einem Display, welches die Vorderseite des Gehäuses bildet, und an dem die Bedienelementeinheit positionierbar ist, entsprechend unterschiedliche Anzeigeinhalte wiedergeben.

Erfindungsgemäß ist die Vorderwand des Gehäuses mit einem Display versehen. Bei diesem Display kann es sich um einen Touchscreen handeln. Das Display kann beispielsweise ein LCD-, ein LED-, ein Micro-LED-, ein OLED-, ein Q-Dot- oder aber auch ein E-Ink-Display sein. Von Bedeutung insoweit ist, dass grundsätzlich sämtliche "aktiven" Displaytypen verwendet werden können, solange ihr Aufbau über keinerlei zwischen der Vorder- und der Rückseite des Displays angeordnete induktive vollständige Abschirmung wie beispielsweise eine durchgehende Metallisierungsschicht o.dgl. verfügt, welche für den Betrieb des jeweiligen Displaytyps auch nicht zwingend erforderlich sind.

Es hat sich überraschenderweise herausgestellt, dass man durch ein LCD-Display hindurch induktiv elektrische Energie transportieren kann, um damit eine an der Vorderseite des Displays angeordnete Bedienelementeinheit betreiben zu können, wobei der Bildinhalt des Displays, durch welches die Ladung induktiv transportiert wird, visuell unbeeinflusst bleibt. Dabei kann man sich z. B. den Qi-Ladestandard für Mobiltelefone zunutze machen.

Es ist ferner möglich, die induktiv gekoppelten Spulen neben der Energieversorgung auch für die Datenkommunikation einzusetzen. So wäre es beispielsweise möglich, nach dem Start des Fahrzeugs und nach der Aktivierung der induktiven Energieübertragung zur der Bedienelementeinheit durch diese bzw. durch eine in dieser befindliche Elektronik rückzumelden, wenn ein Energie-Harvesting-IC o.dgl. Schaltkreis meldet, dass ausreichend Energie für den Betrieb der Bedienelementeinheit übertragen worden ist. Die Datenkommunikation kann uni- oder bidirektional erfolgen (z.B. gemäß dem NFC-Standard), um beispielsweise auf der Anzeigevorrichtung bzw. durch das Anzeigeelement der Bedienelementeinheit gewünschte Informationen anzuzeigen.

Ein Anwendungsbereich der Erfindung betrifft beispielsweise eine Bedienvorrichtung mit einem Display, an dem ein Drehsteller bzw. Dreh-Drücksteller einer Bedienelementeinheit angeordnet ist, über den beispielsweise die Temperaturvorgabe für die Klimaanlage des Fahrzeugs erfolgen kann. Durch Drehen des Drehstellers wird die gewünschte Temperatur eingestellt, wobei die aktuell eingestellte Temperatur durch das Anzeigeelement bzw. die Anzeigevorrichtung der Bedienelementeinheit angezeigt wird. Eine entsprechend erforderliche Sensorik (z.B. kapazitiv, optisch oder resistiv arbeitend) wäre dann in der Bedienelementeinheit vorzusehen. Alternativ könnte die Sensorik eines als Touchscreen ausgeführten Displays genutzt werden, was weiter unten noch im Detail beschrieben werden wird.

In weiterer vorteilhafter Ausgestaltung der Erfindung kann vorgesehen sein, dass die mindestens eine erste Spule oder mindestens eine der ersten Spulen und die mindestens eine zweite Spule oder mindestens eine der zweiten Spule ferner zur drahtlosen uni-oder bidirektionalen Datenkommunikation zwischen der Ansteuer- und Auswerteeinheit der Bedienelementeinheit und einer außerhalb der Bedienelementeinheit und insbesondere an und/oder in dem Gehäuse angeordneten Signal- und Datenverarbeitungseinheit oder einen Kommunikationsinterface vorgesehen sind.

Bei einer weiteren Ausgestaltung der Erfindung kann vorgesehen sein, dass die Bedienelementeinheit mit einem Nahfeld-Signalübertragungsinterface zur drahtlosen Kommunikation mit einem außerhalb der Bedienelementeinheit und außerhalb des Gehäuses befindlichen Kommunikationsinterface versehen ist. Hierbei ist vorgesehen, dass die Bedienelementeinheit über ein Nahfeld-Signalübertragungsinterface wie beispielsweise eine Bluetooth-Schnittstelle verfügt, über die die Datenkommunikation mit einem korrespondierenden Kommunikationsinterface erfolgt, das außerhalb der Bedienelementeinheit und außerhalb des Gehäuses der Bedienvorrichtung, also an anderer Stelle im Fahrzeug angeordnet ist. Über eine derartige drahtlose Kommunikationsverbindung könnte dann eine höherratige Datenkommunikation erfolgen, als dies unter Verwendung der Energieübertragungsspulen der Fall sein könnte.

In weiterer vorteilhafter Ausgestaltung der Erfindung kann vorgesehen sein, dass die Bedienelementeinheit mindestens eine Bedientaste, vorzugsweise eine Bedientastenleiste oder ein Bedientastenfeld mit jeweils mehreren Bedientasten, und/oder einen Drehsteller, insbesondere mit Dreh- und Drückfunktion, und/oder ein Touchpad zur Dateneingabe aufweist und/oder dass das Anzeigeelement bzw. die Anzeigevorrichtung der Bedienelementeinheit als Touchscreen ausgeführt ist.

Zweckmäßig kann es ferner sein, wenn die Vorderseite des Gehäuses ein Display aufweist, wobei die Bedienelementeinheit auf und/oder vor dem Display positioniert und/oder positionierbar ist.

Schließlich ist es zweckmäßig, wenn das Display des Gehäuses eine Hinterleuchtungseinheit mit einer Lichtabgabefläche aufweist, die der Rückseite des Displays zugewandt ist, wobei die mindestens eine erste Spule in der Hinterleuchtungseinheit angeordnet ist.

Schließlich ist es auch möglich, die Bedienelementeinheit mit einer Force-Feedback-Funktionalität oder mit einer Force-Sense-Force-Feedback-Funktionalität in der Bedienelementeinheit selbst zu versehen. Die Bedienelementeinheit kann reversibel abnehmbar positionierbar sein (z.B. durch Adhäsionskleber, Gel, Saugnapf etc.) oder dauerhaft positioniert sein.

Wie bereits oben erwähnt, kann es von Vorteil sein, wenn das Display als Touchscreen ausgeführt ist, der ein kapazitiv und/oder resistiv und/oder optisch arbeitendes Touch-Panel aufweist, wobei die Bedienelementeinheit vor und/oder auf dem Touch-Panel angeordnet ist. Wird ein Display mit Touchfunktion, also ein berührungssensitives Display eingesetzt, so ist es zweckmäßig, wenn eine manuelle Betätigung der Bedienelementeinheit mittels des Touchpad des Displays sensierbar ist.

Die Bedienelementeinheit kann also beispielsweise mit einer Funktionssensorik oder mit einer Anzeigevorrichtung oder mit beidem versehen sein und kann auf einer Gehäusewand ohne oder mit Anzeigefunktion (Display) angeordnet sein. In sämtlichen zuvor genannten Fällen ist das erfindungswesentliche Merkmal darin zu sehen, dass ein elektrischer Verbraucher der Bedienelementeinheit induktiv und durch die Gehäusewand hindurch mit elektrischer Energie versorgt wird.

Zur Erläuterung der Vorteile dieser Ausgestaltung der Erfindung sei gesagt, dass der Innenraum von Fahrzeugen in zunehmendem Maße mit Schaltflächen aufweisenden Touch-Bedieneinheiten ausgestattet wird, über die verschiedene Fahrzeugkomponenten bedient werden können. Andererseits erfreuen sich aber auch sogenannte Drehsteller zur Eingabe und Eingabebestätigung von Betriebsparametern und Bedienfunktionen für Fahrzeugkomponenten zunehmender Beliebtheit. Zur Detektion der aktuellen Drehstellerposition sowie der Eingabebestätigung weisen bekannte Drehsteller eine mitunter recht aufwendig konstruierte Sensorik auf, was die Herstellungskosten erhöht. Wird ein Drehsteller mit benachbart zu diesem angeordneter Touch-Bedieneinheit eingesetzt, so handelt es sich bei beiden um zwei voneinander getrennte Komponenten mit insoweit auch voneinander getrennten Oberflächen.

Insoweit also von Vorteil ist, es, wenn die Bedienvorrichtung für eine Fahrzeugkomponente versehen ist mit
- einer mit manuell betätigbaren Schaltflächen versehbaren Touch-Bedieneinheit, die eine berührungs- und/oder drucksensitive Bedienoberfläche und eine unterhalb dieser angeordnete Sensorik zur Erkennung der Position einer Berührung der und/oder einer Druckausübung auf die Bedienoberfläche aufweist,
- einer mit der Sensorik in Wirkverbindung stehenden Auswerteeinheit zum Empfang von Signalen von der Sensorik und zur Auswertung dieser Signale zur Erkennung einer manuellen Betätigung der Bedienoberfläche sowie zur Auslösung einer durch die Position der Betätigung auf der Bedienoberfläche definierten Bedienfunktion und
- einem Drehsteller, der ein Haltelement und ein an diesem drehbar angeordnetes, manuell betätigbares Drehelement aufweist,
- wobei das Halteelement in einem Teilbereich der Bedienoberfläche der Touch-Bedieneinheit angeordnet ist und mindestens ein von der dem besagten Teilbereich der Bedienoberfläche zugeordneten Sensorik erfassbares Drehstellungs-Detektionselement zur an einer Position im besagten Teilbereich erfolgenden Berührung der und/oder Druckausübung auf die Bedienoberfläche aufweist und
- wobei die Auswerteeinheit anhand von von der Sensorik empfangenen Signalen eine Betätigung der Bedienoberfläche der Touch-Bedieneinheit durch das mindestens eine Drehstellungs-Detektionselement des Drehelements des Drehstellers erkennt und anhand der Position des mindestens einen Drehstellungs-Detektionselements eine dieser Position zugeordnete Bedienfunktion auslöst.

Mit dieser Weiterbildung der Erfindung wird also sinngemäß vorgeschlagen, den Drehsteller oder allgemeiner gesagt die Bedienelementeinheit dann, wenn diese selbst nicht über eine Funktionssensorik verfügt, in die Touch-Bedieneinheit insofern einzubinden, als deren Sensorik zur Erkennung der aktuellen Drehsteller-Verstellposition genutzt wird. Dazu wird nach der Erfindung auf bzw. oberhalb einer manuell betätigbaren Touch-Bedieneinheit mit einer berührungs- und/oder drucksensitiven Bedienoberfläche und einer unterhalb dieser angeordneten Sensorik ein Drehsteller angeordnet, der ein Halteelement und ein an diesem drehbar angeordnetes, manuell betätigbares Drehelement aufweist. Das Drehelement ist mit mindestens einem DrehstellungsDetektionselement versehen, dass sich beim Verdrehen des Drehelements über bzw. auf der Bedienoberfläche der Touch-Bedieneinheit bewegt. Die jeweilige Position des Drehstellungs-Detektionselements kann nun durch die Sensorik der Touch-Bedieneinheit erfasst werden. Auf entsprechende Weise kann auch das Drücken einer Bedientaste der Bedienelementeinheit durch die Sensorik des Touchscreens erkannt werden, wobei die Erkennung der Betätigung auf dem Touchscreen ortsaufgelöst erfolgt.

In demjenigen Bereich der Bedienoberfläche der Touch-Bedieneinheit, in dem das Halteelement des Drehstellers angeordnet ist, können weiterhin durchaus noch Symbolfelder bzw. Schaltflächen zur manuellen Eingabe von Bedienfunktionen angezeigt bzw. vorgesehen werden. Beispielsweise kann der Drehsteller als Ring realisiert sein, so dass durch das Innere des Rings die Bedienoberfläche der Touch-Bedieneinheit visuell zugänglich wäre. Alternativ könnte man die Informationen der Bedienoberfläche der Touch-Bedieneinheit innerhalb des Rings über optische Lichtleitelemente, wie beispielsweise optische Lichtfaserbausteine zur Oberfläche des Drehstellers leiten. Derartige Eingabefelder bzw. Anzeigefelder können aber sehr wohl auf der Bedienoberfläche der Touch-Bedieneinheit außerhalb des zuvor genannten Bereichs dargestellt werden, so dass die erfindungsgemäße Touch-Bedieneinheit sowohl wie herkömmlich durch Berührung bzw. Druckausübung mit dem Finger einer Hand als auch durch Verstellen des Drehstellers bedient werden kann.

Das Halteelement des Drehstellers kann beispielsweise durch Kleben auf der Bedienoberfläche angebracht sein. Es ist aber ebenso denkbar, dass das Halteelement, ohne direkt an der Bedienoberfläche fixiert zu sein, auf dieser angeordnet ist; in diesem Fall ist das Halteelement z.B. an einem Rahmen o.dgl. die Touch-Bedieneinheit umgebenden bzw. daran angrenzenden Element befestigt. Das Drehelement kann als Drehring bzw. als Drehknopf mit oder ohne zusätzliche Betätigungs- und/oder Anzeigeelemente und/oder mit oder ohne ein Touchpad ausgebildet sein.

Als Touch-Bedieneinheit eignet sich eine Bedieneinheit mit kapazitiv, resistiv oder optisch arbeitender Sensorik. Im Falle einer kapazitiv arbeitenden Sensorik ist das manuell zu betätigende Drehelement und das mindestens eine Drehstellungs-Detektionselement elektrisch leitfähig ausgeführt, so dass die Eigenkapazität des Bedieners über das Drehelement und das Drehstellungs-Detektionselement die Potenzialverteilung in der Sensorik beeinflusst. Alternativ können drucksensitiv arbeitende Touch-Bedieneinheiten eingesetzt werden. Diese Touch-Bedieneinheiten sind lokal reversibel deformierbar, wobei der Ort der Deformation resistiv oder optisch (durch sogenannte FTIR Sensoren - Frustrated Total Internal Reflection) erkannt wird.

Durch die erfindungsgemäß vorgesehene Integration der Bedienelementeinheit in Form z.B. mindestens eines Drehstellers auf der Bedienoberfläche einer Touch-Bedieneinheit bedarf es nun keiner Separation der Oberflächen mehr. Es ist eine beliebige Positionierung und Dimensionierung des bzw. der Drehsteller möglich, ohne die Touch-Bedieneinheit verändern zu müssen. Die Auswertung der Drehsteller-Verstellposition erfolgt über die bei der Touch-Bedieneinheit vorhandenen Sensorik, die die (Dreh-)Position des mindestens eines Drehstellungs-Detektionselements, das sich beim Verstellen des Drehstellers auf einer Kreisbahn bewegt, erkennt, so dass für den Drehsteller keine separate Auswerteelektronik erforderlich ist, sondern die Auswerteelektronik genutzt werden kann, die für die manuelle Betätigung von Touch-Bedieneinheiten bereits vorhanden ist.

In weiterer vorteilhafter Ausgestaltung der Erfindung kann ferner vorgesehen sein, dass bei einer manuellen Betätigung einer Schaltfläche der Touch-Bedieneinheit eine akustische, optische und/oder taktile Rückmeldung erfolgt. Derartige Systeme sind als Force Feedback bekannt. Die diesbezügliche akustische, optische und/oder taktile Rückmeldung muss nicht zwingend auch dann erfolgen, wenn eine Bedienfunktion über das Drehelement angewählt wird. Die Eingabe eines Befehls über das Drehelement kann dann beispielsweise durch Niederdrücken des Drehelements erfolgen und ist somit für den Bediener einfach "erkennbar".

Diesbezüglich kann es von Vorteil sein, wenn das Drehelement an dem Halteelement in Richtung auf die Bedienoberfläche der Touch-Bedieneinheit reversibel bewegbar und/oder reversibel gegen die Bedienoberfläche der Touch-Bedieneinheit drückbar angeordnet ist, wobei die Auswerteeinheit eine Betätigung der Bedienoberfläche mittels des mindestens einem Drehstellungs-Detektionselements des Drehelements in dessen in Richtung auf die Bedienoberfläche bewegten und/oder gegen die Bedienoberfläche gedrückten Zustand erkennt. Durch das Niederdrücken des Drehelements zur Eingabe eines Befehls über das Drehelement nähert sich das Drehstellungs-Detektionselement der Bedienoberfläche der Touch-Bedieneinheit an, was die Sensorik der Touch-Bedieneinheit anhand unterschiedlicher Signalstärken erkennt. Handelt es sich bei der Touch-Bedieneinheit um eine resistive oder optisch arbeitende Bedieneinheit mit lokal elastisch verformbarer Bedienoberfläche, so kann die Sensorik auch dann unterschiedlich große Signalstärken detektieren und damit eine Drückfunktion erkennen, wenn mittels des Drehstellungs-Detektionselements gegen die Bedienoberfläche gedrückt wird. Ab einem Mindestdruck bzw. einer Mindestandrückkraft erfolgt die Erkennung, dass das Drehelement gedrückt ist. Damit wird die entsprechende Funktionseingabe akzeptiert.

Insoweit kann es also von Vorteil sein, wenn das Drehelement ein Drück-Detektionselement zur Berührung der und/oder Annäherung an die Bedienoberfläche und/oder zur Druckausübung auf die Bedienoberfläche der Touch-Bedieneinheit beim Drücken des Drehelements aufweist, wobei die Auswerteeinheit den gedrückten Zustand anhand eines Signals der Sensorik bei durch das Drück-Detektionselement erfolgender Berührung der und/oder zumindest Annäherung an die Bedienoberfläche und/oder Druckausübung auf die Bedienoberfläche der Touch-Bedieneinheit erkennt.

In weiterer vorteilhafter Ausgestaltung der Erfindung kann vorgesehen sein, dass die Sensorik der Touch-Bedieneinheit bei Berührung der und/oder Annäherung an die Bedienoberfläche an einer Position ein anderes Signal ausgibt als bei Druckausübung auf die Bedienoberfläche der Touch-Bedieneinheit an der besagten Position. Alternativ bzw. zusätzlich kann die Sensorik bei Druckausübung auf die Bedienoberfläche der Touch-Bedieneinheit an einer Position ein Signal mit einer von der Größe des Drucks abhängigen Signalstärke ausgeben. In all diesen Fällen erkennt die Auswerteeinheit anhand dieser Signale, ob das Drehelement gedrückt ist oder nicht.

Wie bereits oben dargelegt, ist das Halteelement des Drehstellers auf der Bedienoberfläche angeordnet und zwar gegen ungewollte Verschiebungen gesichert. Beispielsweise ist es möglich, dass das Halteelement auf der Bedienoberfläche aufliegend an dieser fixiert ist. Diese Kontaktierung der Bedienoberfläche wird entweder von der Sensorik ignoriert oder aber der Bereich der Bedienoberfläche, in dem das Halteelement fixiert ist, ist frei von einer Sensorik.

Alternativ ist es auch möglich, dass das Haltelement des Drehstellers bzw. der Drehsteller selbst verschiebbar auf der Bedienoberfläche angeordnet ist, um mit dem Drehsteller verschiedene Schaltflächen anzufahren, um dann durch Verdrehung des Drehelements des Drehstellers eine Eingabefunktion auszuüben. Die Fixierung des Drehstellers erfolgt dabei beispielsweise mechanisch.

Die zuvor anhand eines Dreh-(Drück-)Stellers (mit Display) als Beispiel für ein Bedienelement der Bedieneinheit beschriebenen Ausgestaltungen der Erfindung gelten entsprechend auch für Bedientasten (mit Display).

Schließlich ist es denkbar, dass das Drehelement rastend oder freilaufend drehbar an dem Halteelement angeordnet ist.

Die Erfindung wird nachfolgend anhand verschiedener Ausführungsbeispiele und unter Bezugnahme auf die Zeichnung näher erläutert. Im Einzelnen zeigen dabei:
- Fig. 1: eine perspektivische Ansicht auf den vorderen Bereich der Mittelkonsole eines Fahrzeugs mit auf der Mittelkonsole angeordneter TouchBedieneinheit 12 die manuell betätigbare Schaltflächen und einen Drehsteller aufweist,
- Fig. 2: einen Schnitt durch die Touch-Bedieneinheit im Bereich des Drehstellers gemäß II-II der Fig. 1,
- Fig. 3: eine Ansicht auf die Unterseite des Drehstellers gemäß Fig. 2,
- Fign. 4 und 5: ein weiteres Ausführungsbeispiel eines auf der Bedienoberfläche einer Touch-Bedieneinheit angeordneten Drehstellers, der zur Bestätigung einer Eingabe niederdrückbar ist,
- Fign. 6 und 7: ein weiteres Ausführungsbeispiel eines auf der Bedienoberfläche einer Touch-Bedieneinheit angeordneten Drehstellers, der zur Bestätigung einer Eingabe niederdrückbar ist, und
- Fign.8 und 9: ein weiteres Ausführungsbeispiel in Ansicht und im Schnitt.

Im Folgenden wird die Erfindung, nämlich die drahtlose Versorgung der elektrischen/elektronischen Komponenten einer auf ein Display aufgesetzten Bedienelementeinheit anhand eines Drehstellers bzw. Dreh-/Drückstellers beschrieben, dessen Drehposition und gegebenenfalls Drückfunktion ferner durch eine Touch-Sensorik des Displays erkannt wird, was aber für die Erfindung nicht zwingend erforderlich, ggf. aber vorteilhaft ist.

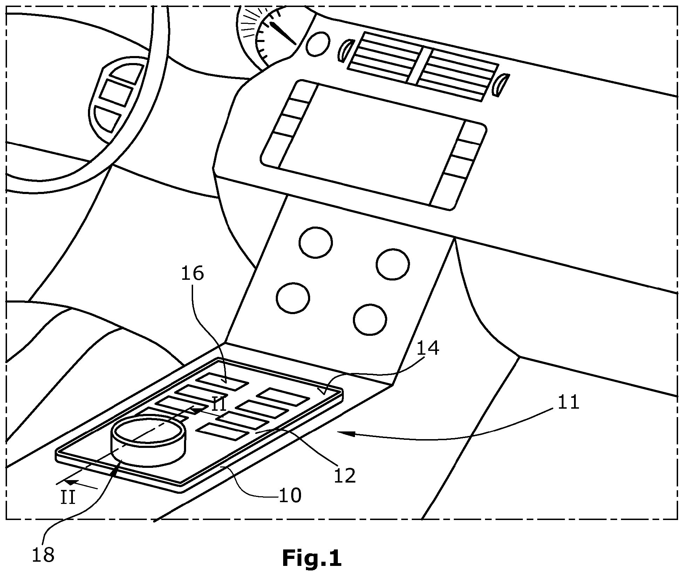

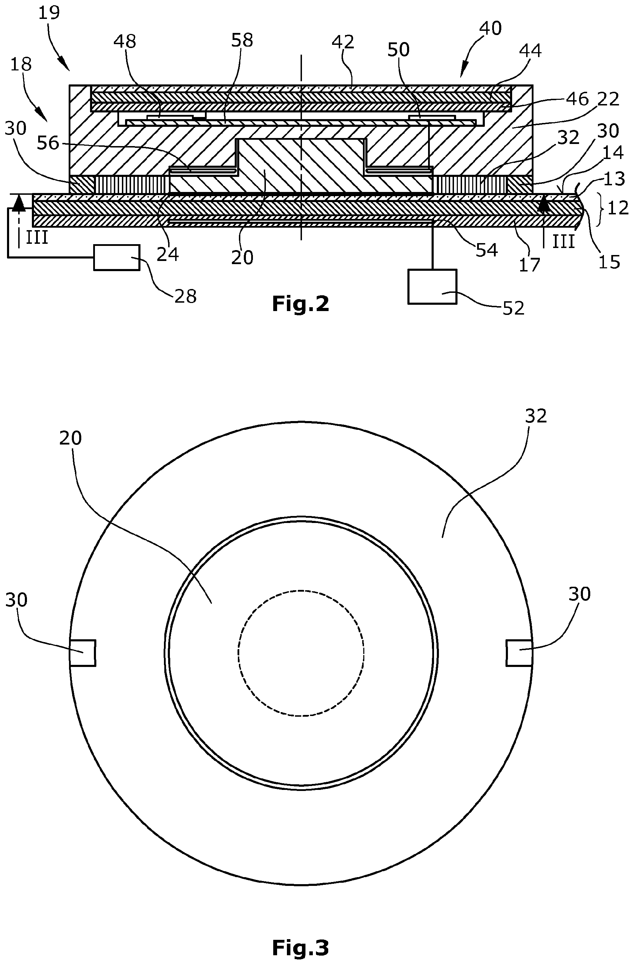

Fig. 1 zeigt perspektivisch eine Ansicht auf die Mittelkonsole eines Fahrzeuginnenraums im Bereich des Übergangs der Mittelkonsole zur Instrumententafel, wobei in diesem Bereich ein in/an einem Gehäuse 10 ausgebildetes Mensch-Maschine-Interface 11 für die Anzeige und/oder Eingabe von Betriebsparametern und Funktionen für ein oder mehrere Fahrzeugkomponenten angeordnet ist. Das Mensch-Maschine-Interface 11 weist ein Display 12 in Form eines Touchscreens mit einem Touch-Panel 13 auf, die mit einer Bedienoberfläche 14 mit auf dieser darstellbaren Schaltflächen 16, einer Anzeigeerzeugungsschicht 15 (z.B. in LCD-Technologie) und einer Hinterleuchtungseinheit 17 versehen ist. Zusätzlich zu den Schaltflächen 16 weist das Display 12 eine auf seiner Bedienoberfläche 14 angeordnete Bedienelementeinheit 19 in Form eines Drehstellers 18 auf, der, wie beispielhaft in Fig. 2 gezeigt, ein Halteelement 20 und ein drehbar an diesem gelagertes Drehelement 22 umfasst. Das Halteelement 20 ist, wie bei 24 angedeutet, auf der Bedienoberfläche 14 festgeklebt.

Erfindungsgemäß ist das Drehelement 22 des Drehstellers 18 mit einer Anzeigevorrichtung 40 versehen, die entweder starr oder mit dem Drehelement 22 mitdrehbar im Drehsteller 18 angeordnet ist. Die Anzeigevorrichtung 40 ist beispielsweise als LCD-Touchscreen ausgebildet und weist ein Touch-Panel 42, ein LCD-Panel 44 und eine Hinterleuchtungseinheit 46 auf. Die Anzeigevorrichtung 40 wird von einer Ansteuer- und Auswerteeinheit 48 angesteuert, die auch die Auswertung der Touch-Sensorik des Touch-Panels 42 vornimmt.

Zur Energieversorgung dient eine Energieversorgungseinheit 50, die induktiv und damit drahtlos mit elektrischer Energie gespeist wird. Hierzu weist die Bedienvorrichtung eine Ansteuereinheit 52 auf, die eine erste Energieübertragungsspule 54 mit Wechselspannung bzw. Wechselstrom versorgt. Diese erste Energieübertragungsspule 54 ist, wie in Fig. 2 zu erkennen ist, innerhalb der Hinterleuchtungseinheit 17 des Displays 12 untergebracht. Im Drehsteller 18, und zwar in dessen Drehelement 22 ist oberhalb des Halteelements 20 eine zweite Energieübertragungsspule 56 angeordnet, die mit der ersten Energieübertragungsspule 54 induktiv gekoppelt ist. Die für den Betrieb der Anzeigevorrichtung 40 und deren Touch-Panel 42 erforderliche Energie wird also induktiv durch das Display 12 transportiert, so dass eine diesbezügliche Verdrahtung vom Gehäuse 10 des Mensch-Maschine-Interface 11 zum Drehsteller 18 nicht erforderlich ist.

Im Drehsteller 18 bzw. im Drehelement 22 kann gegebenenfalls noch weitere Elektronik auf einem PCB 58 untergebracht sein. Diese Elektronik kann beispielsweise ein Kommunikationsinterface aufweisen und ansteuern, mit dem über eine Nahfeld-Kommunikation eine Verbindung zwischen dem Drehsteller 18 und einer entsprechenden Kommunikationsschnittstelle im Fahrzeug hergestellt werden kann. Es ist aber auch denkbar, dass die beiden Energieübertragungsspulen 54,56 begrenzt für eine Datenkommunikation zur Verfügung gestellt werden.

In Fig. 2 ist lediglich eine einzige erste Energieübertragungsspule 54 gezeigt. Alternativ können mehrere derartiger erster Energieübertragungsspulen an der Rückseite des Displays 12 oder innerhalb von dessen Hinterleuchtungseinheit 17 angeordnet sein. Diese ersten Energieübertragungsspulen 54 sind über die Fläche des Displays 12 verteilt angeordnet, so dass dann, wenn der Drehsteller 18, der beispielsweise abnehmbar auf dem Display 12 positionierbar ist, an einer anderen Stelle positioniert wird, dort ebenfalls induktiv mit Energie für den Betrieb seiner Anzeigevorrichtung 40 versorgt werden kann.

Die Touch-Bedieneinheit 12 weist in bekannter Weise eine Sensorik auf, die sich unterhalb der Bedienoberfläche 14 befindet und beispielsweise kapazitiv sensitiv ist. Die von der Sensorik ausgegebenen Signale werden einer Ansteuer- und Auswerteeinheit 28 zugeführt, die auch für die Ansteuerung der Sensorik sorgt.

Nachfolgend wird beschrieben, wie beim Drehsteller 18 die Touch-Sensorik des Displays 12 zur Drehpositionsbestimmung bzw. zur Erkennung einer Drückfunktion des Drehstellers 18 genutzt werden kann. Dies wird anhand mehrerer Ausführungsbeispiele erläutert, wobei für sämtliche Ausführungsbeispiele gilt, dass die Energieversorgung für die elektrischen/elektronischen Komponenten des Drehstellers 18 induktiv und damit drahtlos erfolgt. Es sei an dieser Stelle noch angemerkt, dass die Drehstellung des Drehstellers 18 auch durch eine eigene Sensorik (nicht dargestellt) erfolgen kann, die im Drehsteller 18 verbaut ist, wobei dann die Daten über die Drehstellung und gegebenenfalls die Daten, die eine Drückfunktion kennzeichnen, drahtlos über die Energieübertragungsspulen 54,56 oder über eine andere drahtlose Schnittstelle übertragen werden.

Der Drehsteller 18 weist mindestens ein an der Unterseite seines Drehelements 22 angeordnetes Drehstellungs-Detektionselement 30 auf, das beispielsweise als Segment ausgeführt ist. In dem hier beschriebenen Anwendungsfall gemäß Fig. 2 ist das Drehelement 22 mit zwei derartigen Drehstellungs-Detektionselementen 30 versehen.

Die beiden Drehstellungs-Detektionselemente 30 bewegen sich bei Drehung des Drehelements 22 längs einer Kreisbahn über die Bedienoberfläche 14. Die jeweiligen Positionen der beiden Drehstellungs-Detektionselemente 30 können über die Sensorik erfasst werden. Die Bereiche 32 zwischen den Drehstellungs-Detektionselementen 30 an der Unterseite des Drehelements 22 (siehe auch Fig. 3) sind durch die Sensorik nicht sensierbar. Arbeitet die Sensorik beispielsweise kapazitiv, so kann zumindest die Oberfläche des Drehelements 22 sowie diejenige der Drehstellungs-Detektionselemente 30 elektrisch leitfähig ausgeführt sein, um die Eigenkapazität des Bedieners zur von der Sensorik sensierten Potenzialverschiebung zu nutzen.

Somit ist es erfindungsgemäß möglich, die aktuelle Verdrehposition des Drehstellers 18 mit Hilfe der Sensorik einer Touch-Bedieneinheit 12 zu sensieren und zu detektieren. In Fig. 2 ist ein Ausführungsbeispiel gezeigt, bei dem sich die Drehstellungs-Detektionselemente 30 auf der bzw. in unmittelbarer Nähe oberhalb der Bedienoberfläche 14 bewegt. Ebenso wäre es denkbar, dass beispielsweise bei einer lokal reversibel deformierbaren Bedienoberfläche 14, wie es bei resistiv und/oder optisch arbeitenden Touchsensoren der Fall ist, die Drehstellungs-Detektionselemente 30 mit Druck an der Bedienoberfläche 14 anliegen.

Zur Erkennung der aktuellen Verdrehposition des Drehelements 22 in dem Augenblick, in dem eine Bedienfunktion bzw. Bedienparameter eingegeben werden sollen, existieren verschiedene Lösungsansätze. Beispielsweise wäre es denkbar, dass ein detektierter Stillstand des Drehstellers 18, der für eine bestimmte, relativ kurze Mindestzeit sensiert wird, als Indiz dafür bewertet wird, dass die Verstellung des Drehstellers 18 abgeschlossen ist und die der Verstellung betreffenden Betriebsparameter bzw. Betriebsfunktionen nunmehr eingegeben werden sollen. Das Akzeptieren der Bedieneingabe kann beispielsweise durch eine haptische Rückmeldung bestätigt werden. Derartige insbesondere taktil ausgeführte Rückmeldungen bei Touch-Bedieneinheiten 12 sind grundsätzlich bekannt. Anstelle einer taktilen Rückmeldung bzw. in Ergänzung zu diese kann auch eine akustische und/oder optische Rückmeldung erfolgen. Entsprechende Mechaniken und Mechanismen sind bei bekannten Touch-Bedieneinheiten 12 vorhanden.

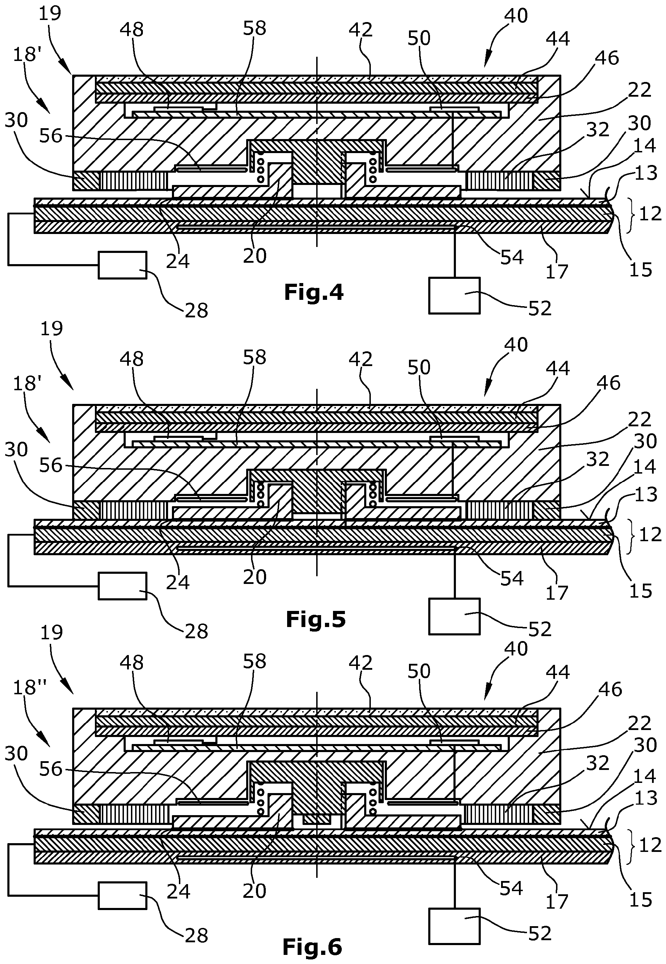

Wesentlich intuitiver ist es allerdings, wenn der Bediener den Drehsteller 18 in einer bestimmten Drehposition niederdrückt, um zu signalisieren, dass er eine Eingabe, und zwar die der Drehstellung entsprechende Eingabe tätigen will. Die Fign. 3 und 4 zeigen im Querschnitt eine entsprechende Ausführungsform eines derartigen Drehstellers 18'. Soweit die in den Fign. 3 und 4 gezeigten Einzelkomponenten denjenigen der Fig. 2 entsprechen, sind sie mit den gleichen Bezugszeichen versehen.

Die Touch-Bedieneinheit 12 gemäß den Fign. 4 und 5 arbeitet beispielsweise ebenfalls kapazitiv. Im nicht gedrückten Zustand des Drehstellers 18' weist dessen Drehelement 22 und dessen Drehstellungs-Detektionselemente 30 einen größeren Abstand zur Bedienoberfläche 14 auf, als im gedrückten Zustand (siehe im Vergleich die Fign. 4 und 5). Die Sensorik erkennt nun anhand der Stärke der kapazitiven Beeinflussung, ob sich die Drehstellungs-Detektionselemente 30 direkt auf der Bedienoberfläche 14 befinden (siehe Fig. 5) oder geringfügig beabstandet dazu (siehe Fig. 4). Dies wird in der Auswerteeinheit 28 ausgenutzt, um zu erkennen dass der Benutzer durch Niederdrücken des Drehelements 22 eine dessen Drehstellung entsprechende Eingabe getätigt hat oder nicht.

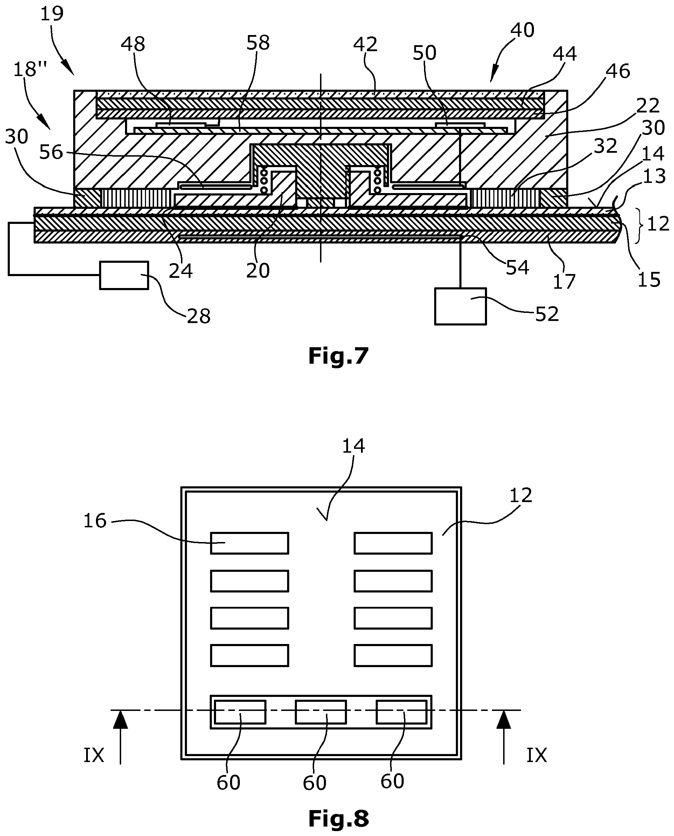

In den Fign. 6 und 7 ist ein weiteres Ausführungsbeispiel eines niederdrückbaren Drehstellers 18" beschrieben, wobei auch hier gilt, dass auch die in diesen Figuren gezeigten Einzelkomponenten, sofern sie funktional bzw. konstruktiv denjenigen der Fign. 2 bis 5 entsprechen, mit gleichen Bezugszeichen versehen sind.

Die Besonderheit im Ausführungsbeispiel des Drehstellers 18" gemäß den Fign. 6 und 7 ist darin zu sehen, dass die Drückfunktion und damit die beabsichtigte Eingabebestätigung durch Niederdrücken des Drehelements 22 anhand der Erkennung eines Drück-Detektionselements 34 erfolgt, das sich beispielsweise wie die Drehstellungs-Detektionselemente 30 an der Unterseite des Drehelements 22 befindet, und zwar z.B. in dessen Zentrum. Spricht also die Sensorik auf die Annäherung des Drück-Detektionselements 34 an die Bedienoberfläche 14 bzw. auf deren Kontaktierung an, wie dies bei Niederdrücken des Drehstellers 18" der Fall ist (siehe Fig. 7), so ist dies ein Indiz dafür, dass die der Drehstellung des Drehelements 22 entsprechende Funktion bzw. Bedieneingabe erfolgen soll.

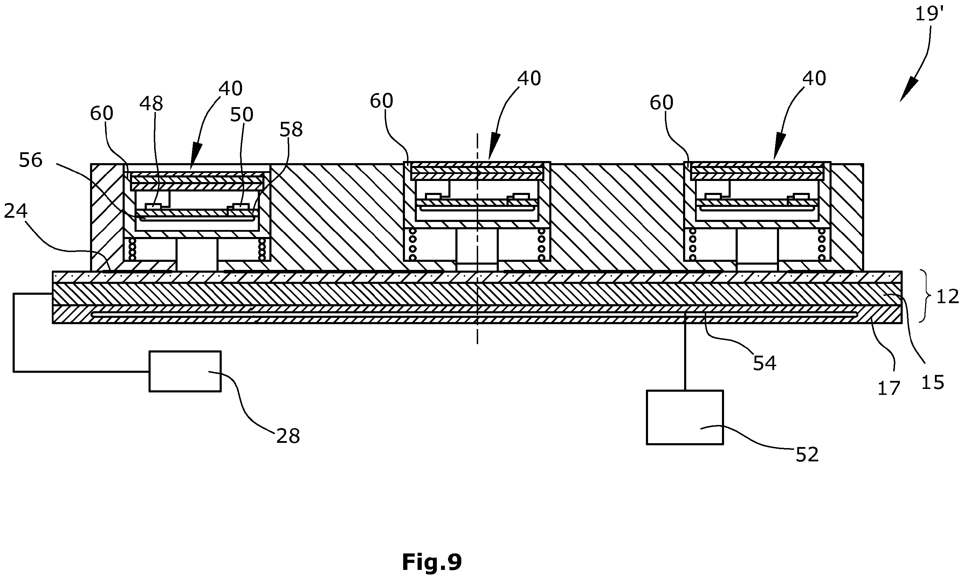

Anhand von Fign. 8 und 9 soll gezeigt werden, dass die Bedienelementeinheit 19' statt eines Drehstellers (auch) Bedientasten 60 aufweisen kann. Auch hier gilt, dass ein in einer Bedientaste 60 angeordnetes Display 40 mittels induktiv übertragener elektrischer Energie versorgt wird, was Gegenstand der Erfindung ist. Die Tastenbetätigung erfolgt z.B. über die Berührungssensorik des Displays 12 (siehe z.B. die in Fig. 9 links gezeigte gedrückte Bedientaste).

### BEZUGSZEICHENLISTE

- 10: Gehäuse
- 11: Mensch-Maschine-Interface
- 12: Display
- 12': Display
- 13: Touch-Panel
- 14: Bedienoberfläche
- 15: Anzeigeerzeugungsschicht (z.B. LCD)
- 16: Schaltflächen
- 17: Hinterleuchtungseinheit
- 18: Drehsteller
- 18': Drehsteller
- 18": Drehsteller
- 19: Bedienelementeinheit
- 19': Bedienelementeinheit
- 20: Halteelement
- 22: Drehelement
- 24: Verklebung des Halteelements auf Bedienoberfläche
- 28: Auswerteeinheit
- 30: Drehstellungs-Detektionselement
- 32: Bereich der Unterseite des Drehelements zwischen den bzw. außerhalb der Drehstellungs-Detektionselemente
- 34: Drück-Detektionselement
- 40: Anzeigevorrichtung
- 42: Touch-Panel der Anzeigevorrichtung
- 44: LCD-Panel der Anzeigevorrichtung
- 46: Hinterleuchtungseinheit der Anzeigevorrichtung
- 48: Ansteuer- und Auswerteeinheit im Drehsteller
- 50: Energieversorgungseinheit
- 52: Ansteuereinheit
- 54: erste Energieübertragungsspule
- 56: zweite Energieübertragungsspule
- 58: PCB
- 60: Bedientaste

## Patentansprüche

1. Bedienvorrichtung für eine Fahrzeugkomponente, insbesondere Mensch-Maschine-Interface (MMI - oder Human-Machine-Interface HMI) für Fahrzeuge, mit
- einem Gehäuse (10), das eine Vorderwand aufweist, die eine Vorderseite mit einer Anzeigefläche und eine der Vorderseite abgewandte Rückseite aufweist, und
- einer auf oder vor der Vorderwand des Gehäuses (10) positionierten oder positionierbaren Bedienelementeinheit (19,19') zum manuellen Auslösen von Bedienfunktionen oder zur manuellen Einstellung von Parametern von Bedienfunktionen für eine Fahrzeugkomponente,
**dadurch gekennzeichnet,**
- **dass** die Bedienelementeinheit (19,19') mindestens ein Bedienelement (18,60), einen elektrischen Verbraucher, eine dem elektrischen Verbraucher zugeordnete Auswerte- und Ansteuereinheit (48) und eine Energieversorgungseinheit (50) aufweist, und
- **dass** zur Speisung der Energieversorgungseinheit (50) der Bedienelementeinheit (19,19') mit elektrischer Energie der Rückseite der Vorderwand zugewandt mindestens eine erste Spule (54) und in und/oder an der Bedienelementeinheit (19,19') mindestens eine mit der mindestens einen ersten Spule (54) induktiv gekoppelte und mit der Energieversorgungseinheit (50) verbundene zweite Spule (56) angeordnet sind.

2. Bedienvorrichtung nach Anspruch 1, **dadurch gekennzeichnet, dass** die mindestens eine erste Spule (54) oder mindestens eine der ersten Spulen (54) und die mindestens eine zweite Spule (56) oder mindestens eine der zweiten Spulen (56) ferner zur drahtlosen uni-oder bidirektionalen Datenkommunikation zwischen der Ansteuer- und Auswerteeinheit (48) der Bedienelementeinheit (19,19') und einer außerhalb der Bedienelementeinheit (19,19') und insbesondere an und/oder in dem Gehäuse (10) angeordneten Signal- und Datenverarbeitungseinheit oder einem außerhalb der Bedienelementeinheit (19,19') und insbesondere an und/oder in dem Gehäuse (10) angeordneten Kommunikationsinterface vorgesehen sind.

3. Bedienvorrichtung nach Anspruch 1 oder 2, **gekennzeichnet durch** eine ggf. weitere drahtlose Datenkommunikationsverbindung zwischen der Bedienelementeinheit (19,19') und einer an und/oder in dem Gehäuse (10) angeordneten Kommunikationsinterface, wobei die weitere drahtlose Datenkommunikationsverbindung zwei Spulen aufweist, von denen die eine in der Bedienelementeinheit (19,19') und die andere außerhalb der Bedienelementeinheit (19,19') angeordnet ist.

4. Bedienvorrichtung nach einem der Ansprüche 1 bis 3, **dadurch gekennzeichnet, dass** die Bedienelementeinheit (19,19') mit einem Nahfeld-Signalübertragungsinterface zur drahtlosen Kommunikation mit einem außerhalb der Bedienelementeinheit (19,19') und außerhalb des Gehäuses (10) befindlichen Kommunikationsinterface versehen ist.

5. Bedienvorrichtung nach einem der Ansprüche 1 bis 4, **dadurch gekennzeichnet, dass** die Bedienelementeinheit (19,19') mindestens eine Bedientaste (60), vorzugsweise eine Bedientastenleiste oder ein Bedientastenfeld mit jeweils mehreren Bedientasten (60), und/oder einen Drehsteller (18,18',18"), insbesondere mit Dreh- und Drückfunktion, und/oder als elektrischer oder elektronischer Verbraucher ein Touchpad zur Dateneingabe und/oder ein Anzeigeelement bzw. eine Anzeigevorrichtung (40) und/oder ein Touchscreen aufweist.

6. Bedienvorrichtung nach einem der Ansprüche 1 bis 5, **dadurch gekennzeichnet, dass** die Vorderseite des Gehäuses (10) ein Display (12,12') aufweist und dass die Bedienelementeinheit (19,19') auf und/oder vor dem Display (12,12') positioniert und/oder positionierbar ist.

7. Bedienvorrichtung nach Anspruch 6, **dadurch gekennzeichnet, dass** das Display (12,12') des Gehäuses (10) eine Hinterleuchtungseinheit (17) mit einer Lichtabgabefläche aufweist, die der Rückseite des Displays (12,12') zugewandt ist, und dass die mindestens eine erste Spule (54) in der Hinterleuchtungseinheit (17) angeordnet ist.

8. Bedienvorrichtung nach Anspruch 6 oder 7, **dadurch gekennzeichnet, dass** das Display (12,12') als Touchscreen ausgeführt ist und ein kapazitiv und/oder resistiv und/oder optisch arbeitendes Touch-Panel (13) aufweist, und dass die Bedienelementeinheit (19,19') vor und/oder auf dem Touch-Panel (13) angeordnet ist.

9. Bedienvorrichtung nach einem der Ansprüche 1 bis 8, **dadurch gekennzeichnet, dass** die Bedienelementeinheit (19,19') mit einer in der Bedienelementeinheit (19,19') vorhandenen Force-Feedback-Funktionalität oder mit einer Force-Sense-Force-Feedback-Funktionalität versehen ist.

10. Bedienvorrichtung nach Anspruch 8 oder 9, **dadurch gekennzeichnet, dass** eine manuelle Betätigung der Bedienelementeinheit (19,19') mittels des Touch-Panel (13) des Displays (12,12') sensierbar ist.

11. Bedienvorrichtung nach einem der Ansprüche 1 bis 10, **dadurch gekennzeichnet, dass** die Bedienelementeinheit (19,19') fest positioniert oder reversibel positionierbar ist.

## Claims

1. An operating device for a vehicle component, in particular a human-machine interface (HMI) for vehicles, comprising
- a housing (10) having a front wall comprising a front face with a display surface and a rear face facing away from the front face, and
- an operating element unit (19, 19') positioned and/or positionable on and/or in front of the front wall of the housing (10) for manually triggering operating functions or for manually adjusting parameters of operating functions for a vehicle component,
**characterized in that**
- the operating element unit (19, 19') comprises at least one operating element (18, 60), an electric consumer, an evaluation and control unit (48) assigned to the electric consumer, and an energy supply unit (50), and
- in order to supply electric energy to the energy supply unit (50) of the operating element unit (19, 19') at least one first coil (54) is arranged so as to face the rear face of the front wall, wherein at least one second coil (56), which is inductively coupled to the at least one first coil (54) and is connected to the energy supply unit (50), is arranged in and/or on the operating element unit (19, 19').

2. The operating device according to claim 1, **characterized in that** the at least one first coil (54) or at least one of the first coils (54) and the at least one second coil (56) or at least one of the second coils (56) is further provided for a wireless unidirectional or bidirectional data communication between the control and evaluation unit (48) of the operating element unit (19, 19') and a signal and data processing unit arranged outside the operating element unit (19, 19') and particularly on and/or in the housing (10), or a communication interface arranged outside the operating element unit (19, 19') and particularly on and/or in the housing (10).

3. The operating device according to claim 1 or 2, **characterized by** an optional further wireless data communication link between the operating element unit (19, 19') and a communication interface arranged on and/or in the housing (10), wherein the further wireless data communication link comprises two coils, one of which is arranged in the operating element unit (19, 19') and the other outside the operating element unit (19, 19').

4. The operating device according to any one of the claims 1 to 3, **characterized in that** the operating element unit (19, 19') is provided with a near field signal transmission interface for wireless communication with a communication interface located outside the operating element unit (19, 19') and outside the housing (10).

5. The operating device according to any one of the claims 1 to 4, **characterized in that** the operating element unit (19, 19') comprises at least one operating key (60), preferably an operating key bar or an operating key field with respectively several operating keys (60), and/or a rotary adjuster (18, 18', 18"), particularly with a rotary and press function, and/or as an electric or electronic consumer a touchpad for data entry, and/or a display element or a display device (40), and/or a touchscreen.

6. The operating device according to any one of the claims 1 to 5, **characterized in that** the front face of the housing (10) comprises a display (12, 12') and the operating element unit (19, 19') is positioned or positionable on and/or in front of the display (12, 12').

7. The operating device according to claim 6, **characterized in that** the display (12, 12') of the housing (10) comprises a backlight unit (17) with a light emitting surface facing the back of the display (12, 12'), and the at least one first coil (54) is arranged in the backlight unit (17).

8. The operating device according to claim 6 or 7, **characterized in that** the display (12, 12') is adapted as a touchscreen and comprises a capacitive and/or resistive and/or optical touch panel (13), and the operating element unit (19, 19') is arranged in front of and/or on the touch panel (13).

9. The operating device according to any one of the claims 1 to 8, **characterized in that** the operating element unit (19, 19') is provided with a force-feedback function or a force-sense/force-feedback function in the operating element unit (19, 19').

10. The operating device according to claim 8 or 9, **characterized in that** a manual actuation of the operating element unit (19, 19') can be sensed by means of the touch panel (13) of the display (12, 12').

11. The operating device according to any one of the claims 1 to 10, **characterized in that** the operating element unit (19, 19') is positioned in a fixed or reversible manner.

## Revendications

1. Dispositif de commande pour un composant de véhicule, en particulier une interface homme-machine (IHM) pour véhicule, doté
- d'un boîtier (10), lequel comporte une paroi avant, laquelle comporte une face avant avec une surface d'affichage et une face arrière se détournant de la face avant, et
- d'une unité d'élément de commande (19, 19') positionnée ou positionnable sur ou devant la paroi avant du boîtier (10) destinée au déclenchement manuel de fonctions de commande ou au réglage manuel de paramètres de fonctions de commande pour un composant de véhicule, **caractérisé**
- **en ce que** l'unité d'élément de commande (19, 19') comporte au moins un élément de commande (18, 60), un récepteur électrique, une unité de contrôle et de pilotage (48) associée au récepteur électrique et une unité d'alimentation en énergie (50), et
- **en ce qu'**au moins une première bobine (54) est disposée en face de la face arrière de la paroi avant pour alimenter en énergie électrique l'unité d'alimentation en énergie (50) de l'unité d'élément de commande (19, 19') et au moins une deuxième bobine (56) couplée inductivement à la première bobine (54) et reliée à l'unité d'alimentation en énergie (50) est disposée dans et/ou sur l'unité d'élément de commande (19, 19').

2. Dispositif de commande selon la revendication 1, **caractérisé en ce que** l'au moins une première bobine (54) ou au moins une des premières bobines (54) et l' au moins une deuxième bobine (56) ou au moins une des deuxièmes bobines (56) sont en outre prévues pour la communication de données sans fil uni- ou bidirectionnelle entre l'unité de contrôle et de pilotage (48) de l'unité d'élément de commande (19, 19') et une unité de traitement de signaux et de données disposée à l'extérieur de l'unité d'élément de commande (19, 19') et en particulier sur et/ou dans le boîtier (10) ou une interface de communication disposée à l'extérieur de l'unité d'élément de commande (19, 19') et en particulier sur et/ou dans le boîtier (10).

3. Dispositif de commande selon la revendication 1 ou 2, **caractérisé par** une liaison de communication de données sans fil éventuellement supplémentaire entre l'unité d'élément de commande (19, 19') et une interface de communication disposée sur et/ou dans le boîtier (10),dans lequel la liaison de communication de données sans fil éventuellement supplémentaire comporte deux bobines, desquelles l'une est disposée dans l'unité d'élément de commande (19, 19') et l'autre est disposée à l'extérieur de l'unité d'élément de commande (19, 19').

4. Dispositif de commande selon l'une des revendications 1 à 3, **caractérisé en ce que** l'unité d'élément de commande (19, 19') est prévue avec une interface de transmission de signal en champ proche pour la communication sans fil avec une interface de communication se trouvant à l'extérieur de l'unité d'élément de commande (19, 19') et à l'extérieur du boîtier (10).

5. Dispositif de commande selon l'une des revendications 1 à 4, **caractérisé en ce que** l'unité d'élément de commande (19, 19') comporte au moins une touche de commande (60), de préférence une barre de touches de commande ou un champ de touches de commande avec respectivement plusieurs touches de commande (60), et/ou un actuateur rotatif (18, 18', 18''), en particulier avec fonction de rotation et de pression, et/ou, en tant que récepteur électrique ou électronique, un clavier tactile pour la saisie de données et/ou un élément d'affichage ou un dispositif d'affichage (40) et/ou un écran tactile.

6. Dispositif de commande selon l'une des revendications 1 à 5, **caractérisé en ce que** la face avant du boîtier (10) comporte un écran (12, 12') et **en ce que** l'unité d'élément de commande (19, 19') est positionnée ou positionnable sur ou devant l'écran (12, 12').

7. Dispositif de commande selon la revendication 6, **caractérisé en ce que** l'écran (12, 12') du boîtier (10) comporte une unité de rétroéclairage (17) dotée d'une surface émettrice de lumière, laquelle fait face à la face arrière de l'écran (12, 12'), et **en ce que** l'au moins une première bobine (54) est disposée dans l'unité de rétroéclairage (17).

8. Dispositif de commande selon la revendication 6 ou 7, **caractérisé en ce que** l'écran (12, 12') est réalisé comme écran tactile et comporte un panneau tactile (13) fonctionnant de manière capacitive et/ou résistive et/ou optique, et **en ce que** l'unité d'élément de commande (19, 19') est disposée devant et/ou sur le panneau tactile (13) .

9. Dispositif de commande selon l'une des revendications 1 à 8, **caractérisé en ce que** l'unité d'élément de commande (19, 19') est prévue dotée d'une fonction de retour de force présente dans l'unité d'élément de commande (19, 19') ou dotée d'une fonction haptique.

10. Dispositif de commande selon la revendication 8 ou 9, **caractérisé en ce qu'**un actionnement manuel de l'unité d'élément de commande (19, 19') est détectable au moyen du panneau tactile (13) de l'écran (12, 12').

11. Dispositif de commande selon l'une des revendications 1 à 10, **caractérisé en ce que** l'unité d'élément de commande (19, 19') est positionnée de manière fixe ou positionnable de manière réversible.
